# EUROPEAN PATENT APPLICATION

(11) **EP 1 530 091 A1**
(43) Date of publication of application: **11.05.2005**
(21) Application number: 04078049.6
(22) Date of filing: 05.11.2004
(51) Int. Cl.: G03F 7/20

(54) **Radiation detector**

(30) Priority: 07.11.2003 EP 03078516
(71) Applicant: ASML Netherlands B.V., 5504 DR Veldhoven (NL)
(72) Inventor: Bakker, Levinus P., NL-5708 ZT Helmond (NL)
(74) Representative: van Westenbrugge, Andries

(57) **Abstract**

Radiation flux is detected indirectly, i.e. not the primary radiation flux (35) itself is measured but instead a secondary radiation flux (41). The secondary radiation flux is generated by conversion of the primary flux into the secondary radiation flux. A measurement system that is present, is able to derive from the measurement signal generated by the radiation emitted by the fluorescent layer the following quantities: the dose, the intensity the EUV radiation, the amount of contamination of the optical layer of the optical component.

## Description

The invention relates to a detector arrangement comprising a detector and a measurement system, said detector being arranged to provide a measurement signal to said measurement system in response to a first type of radiation incident on said detector, said detector designed to be arranged in the vicinity of an optical component.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

From US 2003/0052275 A1 an EUV radiation flux detector whose calibration does not fluctuate is known. The idea presented in US 2003/0052275 A1 is to embed an integral EUV photodiode behind a multilayer reflection stack. Between the photodiode and the multilayer reflection stack a planarizing layer is present. The planarizing layer serves two functions, first it defines a micro-fine surface suitable for the growth of the multilayer reflection stack, and second it provides an insulating layer between the multilayer reflection stack and its surroundings. As the detector from US 2003/0052275 A1 is relatively insensitive to changes in environmental conditions, for instance contamination of the surface of the sensor, it can not be used to obtain an idea of the contamination on the surface of an optical component.

European patent application no. 02256037.9 (P-0349.000) filed on August 30, 2002 in the name of the applicant describes a sensor that detects emitted radiation from the surface of a reflector. The emitted radiation is generated when electrons, that are excited into a higher energy state by an incident beam of radiation on the surface, return to a lower energy state. During this process, also a part of the incident radiation will be converted into heat. The emitted radiation will have a longer wavelength than the incident radiation. The emitted radiation is also called luminescent radiation. The sensor is positioned in front of the reflector.

Measuring the EUV radiation flux in a lithographic apparatus is critical to maximizing performance. Radiation flux is the radiation energy per unit time per unit area in J/sec/m². Information on the EUV radiation flux is needed to determine EUV dose and intensity and to determine the amount of contamination on optical components. Since EUV radiation losses should be kept as low as possible, it is important that an EUV radiation flux detector blocks an EUV beam of radiation as little as possible. Prior art techniques for measuring the EUV radiation flux measure scattered EUV radiation or, both or alternatively, use the "surplus" radiation of a projection beam i.e. the part of the projection beam that is not used for lithographic purposes to determine the EUV radiation flux. These techniques, unfortunately, can not be employed at every position in a lithographic apparatus. At the moment, also the secondary electron flux emitted from an optical component while irradiated with EUV radiation is used as a measure for the EUV radiation flux. However, there are several problems in connection with this technique. For instance, the presence of electric fields is required. These electric fields accelerate positive ions towards an optical component, which results in unwanted sputtering of such an optical component. Also, due to the high electron current, the secondary electron flux is a non-linear function of the EUV radiation flux. It is presently an open question whether detection of EUV radiation flux by measuring the secondary electron flux is possible at all.

It is therefore an aim of the present invention to disclose an assembly for determining EUV radiation flux in a lithographic projection apparatus more conveniently and more reliable and at more optical components than is presently possible.
The invention is therefore characterized in that said optical component comprises at least
- an optical layer to, when said detector assembly is in use, receive an amount of a second type of radiation, a fraction of said amount of said second type of radiation passing through said optical layer,
- a layer on which said fraction impinges, said layer converting said fraction to said first type of radiation,
   and
- a substrate substantially transparent to said first type of radiation, said measurement system being arranged to derive from said measurement signal at least one of a dose of said amount of second type of radiation, an intensity of said second amount of radiation and an amount of contamination of said optical layer.

Advantages of this invention are manifold: for detection use is made of the not useful radiation (e.g. radiation that is not reflected and would anyhow be lost), no electric field is necessary, no changes are necessary to optical components presently available in a lithographic projection apparatus, no additional light sources are required, measured signals are a linear function of EUV dose. The layer that converts the radiation fraction from a second wavelength to a first wavelength may typically be a (large) fluorescent layer. Such a layer is relatively easy to produce in comparison to, for instance, a large photodiode. In addition, spatially resolved radiation measurements are possible with such a layer. Radiation dose and intensity and the amount of contamination on the surface of an optical component, are important parameters in a lithographic apparatus. An optical component generally comprises an optical layer (or coating) deposited on a substrate. In particular for EUV radiation, a problem is that the substrate, though required to support the optical layer, is a radiation absorber. By converting the EUV radiation to radiation for which the substrate is relatively transparent, this problem is as well solved by the present invention.

In a further embodiment the invention is characterized in that said layer comprises a host lattice and at least one ion and said host lattice comprises at least one of calcium sulfide (CaS), zinc sulfide (ZnS) and yttrium aluminum garnet (YAG) and said ion comprises at least one of Ce³⁺, Ag⁺ and Al³⁺. These materials have proven to be particularly suited for layers that have to convert radiation. These materials convert (EUV) radiation to radiation with a longer wavelength and with a relatively high efficiency.

In a further embodiment the invention is characterized in that said detector comprises at least one of a CCD camera, a CMOS sensor, and a photodiode array. The previous enumeration is not limited nor complete and alternative detectors may present themselves readily to the skilled person. An advantage of these detectors is that by employing them, position dependent measurements are possible.

In still a further embodiment, the invention is characterized in that said optical component comprises a multilayer stack. These types of mirrors for instance comprising alternating layers of molybdenum (Mo) and silicon (Si) are frequently encountered in lithographic projection apparatus working with a EUV radiation source.

The invention also relates to a measurement assembly comprising a detector arrangement as described above and an optical component located in front of said detector. This set up is particularly suited for dose/intensity and/or contamination measurements on optical components. This embodiment of the invention has advantages similar to advantages listed above.

In still a further embodiment, the invention is characterized in that said second type of radiation comprises at least one of EUV and IR radiation. For these types of radiation some substrates are substantially transparent, which means that these types may advantageously be used.

The invention also relates to a measurement assembly for determining an amount of contamination of an optical layer of an optical component, comprising a radiation source arranged to provide, in use, a measurement beam towards said optical component, a detector arranged to receive at least a portion of said measurement beam after said measurement beam has passed through said optical component and a measurement system connected to said detector to receive a measurement signal characterized in that the measurement system is arranged to determine an amount of contamination of said surface from said measurement signal. This assembly provides measurements insensitive to variations in the radiation source of the lithographic apparatus.

The invention also relates to a lithographic apparatus comprising.
- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate,
characterized in that the lithographic projection apparatus comprises a measurement assembly as described above.

The invention also relates to a method for determining at least one of a dose of radiation, an intensity of radiation and an amount of contamination of an optical layer comprising:
- providing a detector arrangement comprising a detector and a measurement system, said detector being arranged to provide a measurement signal to said measurement system in response to radiation incident on said detector,
characterized by
- providing said detector behind an optical component said optical component comprising said optical layer to, when said detector arrangement is in use, receive said radiation a fraction of said radiation passing through said optical layer and
- calibrating said measurement system to derive from said radiation a measurement signal relating to at least one of a dose of said radiation, an intensity of said radiation and an amount of contamination of said optical layer.

The invention also relates a device manufacturing method comprising the steps of:
- providing a substrate;
- providing a projection beam of radiation using an illumination system;
- using patterning means to impart the projection beam with a pattern in its cross-section; and
- projecting the patterned beam of radiation onto a target portion of the substrate,
characterized by
using a lithographic apparatus as described above.

The invention also relates to a detector arrangement comprising a photodiode and a measurement system, said photodiode being arranged to provide a measurement signal to said measurement system said photodiode designed to be arranged behind an optical component, said optical component comprising an optical layer to, in use, receive an amount of radiation characterized in that said measurement signal is related to an amount of contamination on said optical layer. This provides the possibility to asses the contamination of the optical layer of an optical component.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figure 2 depicts the invention in a first embodiment;
Figure 3 depicts the invention in a second embodiment in which a fluorescent layer is present,
Figure 4 depicts the invention in a third embodiment used in connection with a separate radiation source,
Figure 5a and 5b show two transmission graphs for a multilayer stack with and without the presence of a carbon layer, and
Figure 6 shows a transmission ratio calculated on the basis of figure 5a.

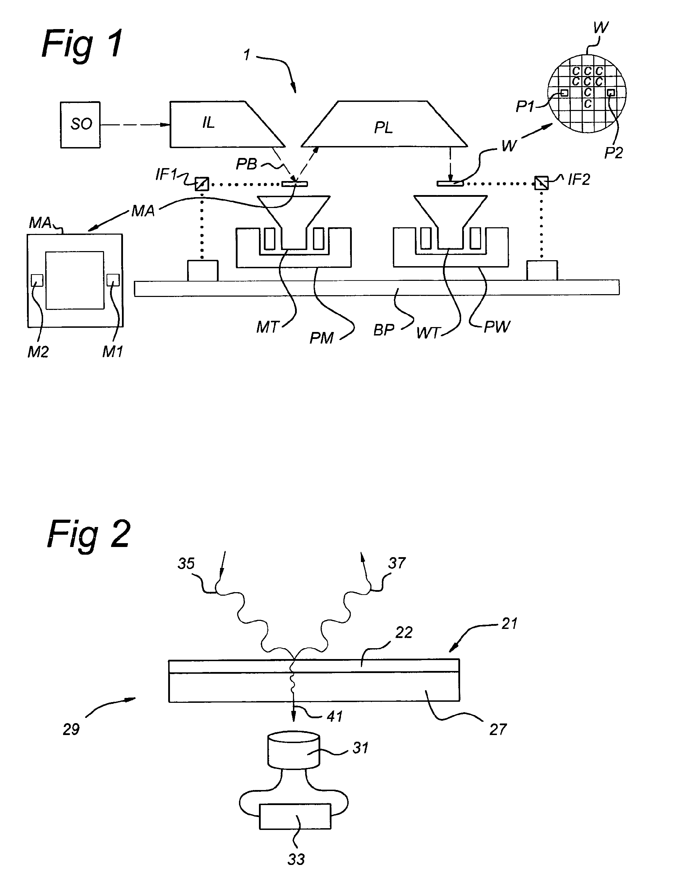

Figure 1 schematically depicts a lithographic apparatus according to a particular embodiment of the invention. The apparatus comprises:
- an illumination system (illuminator) IL for providing a projection beam PB of radiation (e.g. UV or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as σ-outer and σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

A measurement assembly 29 according to the invention is shown in fig. 2. In fig. 2 an optical component 21 is shown. The optical component 21 having a optical layer 22 deposited on a substrate 27, may typically be a lens (for the concept of a lens, see above) or a (multilayer) mirror, reticle etc. The invention is particularly suited for optical components with a reflective optical layer 22. Radiation 35 from an EUV radiation source (not shown in fig. 2) is incident on the optical component 21. Some of the radiation is transmitted through the optical component 21 as indicated by reference numeral 41. The larger part of the radiation 35, however, is reflected by the optical layer 22 of the optical component 21 as indicated by reference numeral 37. A detector 31 is present in the vicinity of the optical layer 22 of the optical component 21 as long as it does not block the radiation 35 and/or 37. The detector 31 is connected to a measurement system 33 receiving a signal form the detector 31. The measurement system 33 may e.g. be a suitably programmed computer or a measurement arrangement with suitable analogue and/or digital circuits. The substrate 27 must be substantially transparent to the radiation 35. A 200 nm thick silicon (Si) layer may be used for this purpose. Note that the optical component 21 as shown in fig. 2 comprises at least an optical layer 22 deposited on a substrate 27.

The invention functions in the following way. Although reflection of EUV radiation 35 through the optical component 21 is maximized, there will always be a certain fraction 41 of the EUV radiation 35 that passes through the optical layer 22 and the component 21. This radiation fraction 41 hits the detector 31. Upon incidence of the radiation fraction 41, the detector 31 generates a measurement signal to the measurement system 33. The measurement signal is an indication of changes in EUV dose on optical layer 22 and/or intensity and/or of contamination on optical layer 22. If there are no changes in the measurement signal one may assume that both the dose and the contamination have not been changed. If the measurement signal changes abruptly, one may assume that this is due to abrupt dose changes. However, slow changes of the measurement signal may indicate increasing contamination of the optical layer 22. Moreover, several mirrors in the apparatus may be provided with a sensor behind them, thus, providing the option to send more measurement signals to measurement system 33. The measurement system 33, may, then, be arranged to evaluate all these signals and to conclude about changes of dose and/or contamination based on several measurements. Both absolute -- after appropriate gauging -- and relative measurements of radiation flux are possible, "relative" meaning the difference in the amount of radiation detected on a moment t1 and the amount of radiation detected on a moment t2, from which it is possible to derive data on contamination/dose and intensity. Also (EUV) radiation sensing measurements in general (e.g. alignment, further optical properties) are possible. In this embodiment the substrate 27 is transparent to the second type radiation 41 (35).

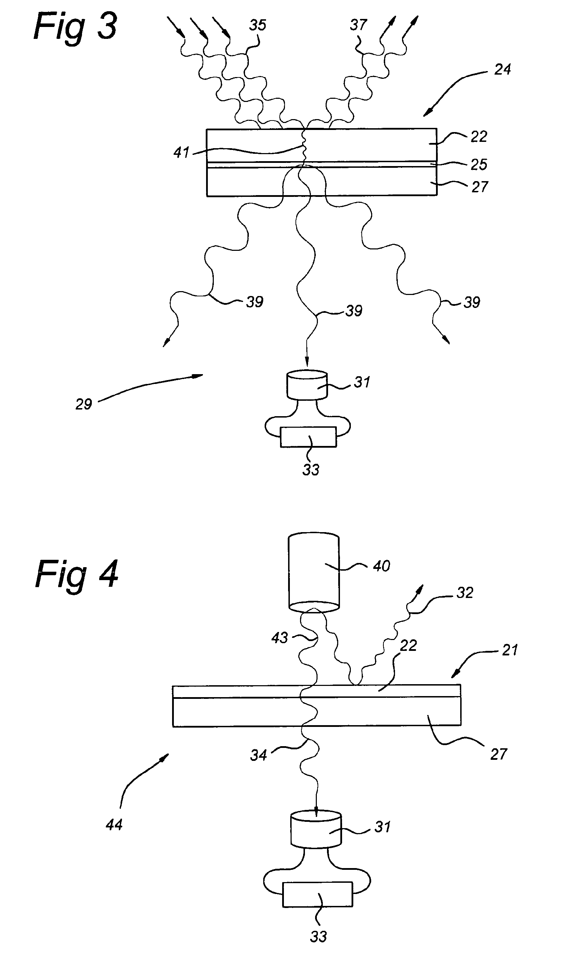

In fig. 3, a further embodiment of the invention is shown. The same reference numerals apply as previously used in fig. 2. By contrast with fig. 2, the optical component in fig. 3 is referred to with reference numeral 24. In addition, a fluorescent layer 25 is present on a substrate 27. The fluorescent layer 25 can also be incorporated into the substrate 27, i.e. for instance using a yttrium aluminum garnet (YAG) crystal as a substrate. The optical layer 22 is deposited on the fluorescent layer 25. The radiation emerging from the fluorescent layer 25 is referred to with reference numeral 39. The substrate 27 must be substantially transparent to this radiation 39. As is disclosed in EP1182511, filed August 23, 2001 the fluorescent layer 35 comprises a host lattice and at least one ion. The host lattice may comprise at least one of calcium sulfide (CaS), zinc sulfide (ZnS) and yttrium aluminum garnet (YAG). The ion may comprise at least one of Ce³⁺, Ag⁺ and Al³⁺. Note that the optical component 24 as shown in fig. 3 comprises by contrast to the optical component 21 shown in fig. 2 at least an optical layer 22 deposited on a substrate 27 and a fluorescent layer 25 deposited in between.

This embodiment functions in the following way. Part 37 of the radiation 35 is reflected by the optical layer 22 of the optical component 24. A fraction of the radiation 35, referred to with 41 passes through the optical component 24 and hits the fluorescent layer 25. The fluorescent layer 25 converts, the radiation 41 into radiation 39 that, at least partly, impinges on the detector 31. It is to be noted that the conversion does not necessarily imply a 100% (or close to 100%) conversion. Generally speaking the wavelength of the radiation 39 will be different from the wavelength of the radiation 35, 37 or 41. As will be appreciated by the skilled person, the substrate 27 must be substantially transparent to the radiation 39. The detector 31 is designed to measure the amount of radiation 39. This radiation is correlated to the amount of radiation 35 by several conversion factors. If these conversion factors are known, the amount of radiation 35 can be determined. The fluorescent layer 25 may be large. Such a layer is relatively easy to produce in comparison to, for instance, a large photodiode. In addition, spatially resolved radiation measurements are possible with such a layer. In this embodiment the substrate 27 is transparent to radiation 39.

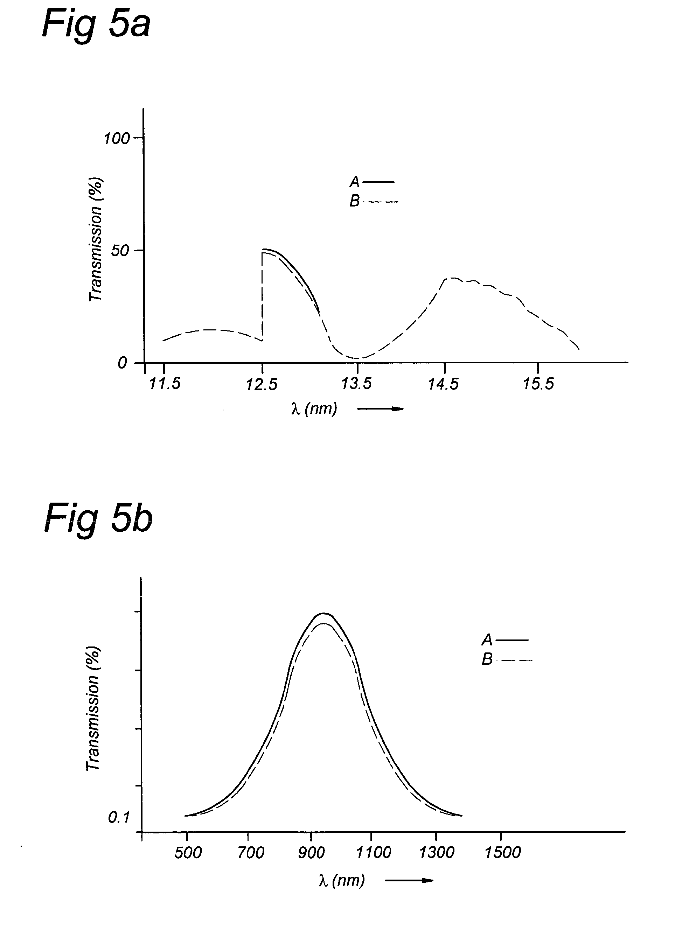

In fig. 4, a further embodiment of the invention is shown. In fig. 4, in which the same reference numerals are used as in fig.'s 2 and 3, a separate radiation source 40 such as a laser is used. The radiation source 40 provides a measurement beam 43. A first portion 34 of the measurement beam 43 will pass through the optical component 21. A second portion 32 will be reflected. By "separate" it is to be understood here that whereas the measurements in fig.'s 2 and 3 are carried out "on line" (i.e. during operation of the lithographic projection apparatus) and use the projection beam PB of radiation of the radiation source SO present in the lithographic projection apparatus, the radiation source 40 will be used for measurement purposes only. Depending on the wavelength of the measurement beam 43 provided by the radiation from source 40 and the amount of interference between the projection beam PB and the measurement beam 43 from the radiation source 40 (or in fact between the projection beam PB and the first portion 34 of the measurement beam 43) both "on line" and "off line" measurements may be done. The measurement beam 43 by the radiation source 40 may typically comprise radiation generated by a laser (such as a low power Nd:YAG laser) or another infra red (IR) radiation source. This embodiment can be used to accurately scan an optical component. Further advantages are an "independent" contamination measurement (i.e. a contamination measurement that is not blurred/disturbed by a dose measurement) is possible. In this embodiment, use is made of the fact that in the transmission spectrum of a multilayer stack there are wavelength intervals where the stack is relatively transparent. One of these intervals is located around 13.5 nm (in the EUV range of the electromagnetic spectrum) and one interval is located around 1000 nm (in the IR range of the electromagnetic spectrum). This will be appreciated from the accompanying figures 5a and 5a. In this embodiment the substrate 27 is transparent to radiation 34 (43). Although here the explanation is directed to an optical component 21 similar to the optical component shown in fig. 2, the skilled person will appreciate that this embodiment may be combined with an optical component 24 as shown in fig. 3, without substantially departing from the scope of the present invention.

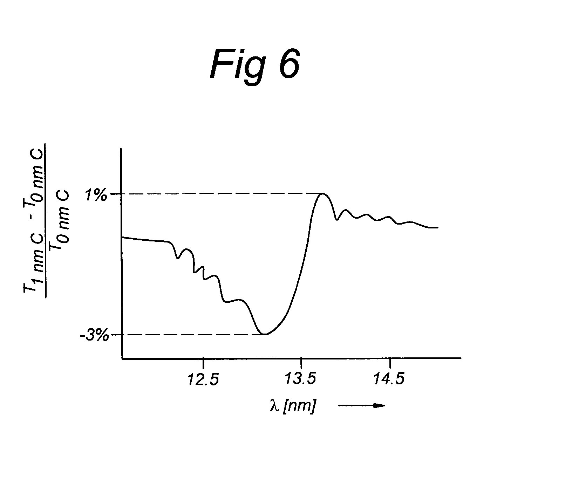

The figures 5a and 5b show the calculated transmission for 40 bi-layers of 2.5 nm Mo and 4.4 nm Si. Radiation around these ranges is relatively easy transmitted through the stack as shown by graph A in fig 5a and 5b. The transmission is affected by a contaminating 1 nm thick layer of carbon (C) on the multilayer stack (graph B). It is well known that contaminant particles, such as hydrocarbon molecules and water vapor, are present in lithographic projection apparatus. These contaminant particles may include debris and by-products that are sputtered loose from the substrate, for example by an EUV radiation beam. Said particles may also include debris from the EUV source, contaminants liberated at actuators, conduit cables, etc. Since parts of lithographic projection apparatus, such as the radiation system and the projection system, are generally at least partially evacuated, these contaminant particles tend to migrate to such areas. The particles then adsorb to the surfaces of the optical components located in these areas. This contamination of the optical components causes a loss of reflectivity, which may adversely affect the accuracy and efficiency of the apparatus, and may also degrade the components' surfaces, thus reducing their useful lifetime. Although not clearly visible from fig 5a (due to the small differences compared to the scale of the drawing) the transmission is always different i.e. more or less without or with the 1 nm layer of carbon. The ratio (the transmission with a layer of 1nm carbon - the transmission without a layer of 1nm carbon)/(the transmission without a layer of 1nm carbon) may vary between + 1 % and -3 %. This ratio is shown in fig. 6. By detecting the radiation through the multilayer stack the intensity/dose and or contamination on the stack can be derived. In other words: if one measures the transmission of radiation through the multilayer, an idea of the amount of carbon contamination may be obtained. The transmission of the radiation is wavelength dependent.

While specific embodiments of the invention have been described above, it will be appreciated that the invention may be practiced otherwise than as described. For instance, in the set-up of fig. 4 the optical component 21 may be provided with a substrate 27 and a fluorescent layer 25 too. The description is not intended to limit the invention.

## Claims

1. Detector arrangement comprising a detector (31) and a measurement system (33), said detector (3 1 ) being arranged to provide a measurement signal to said measurement system (33) in response to a first type of radiation (39) incident on said detector (31), said detector (31) designed to be arranged in the vicinity of an optical component (24), **characterized in that** said optical component (24) comprises at least
- an optical layer (22) to, when said detector assembly is in use, receive an amount of a second type of radiation (35), a fraction (41) of said amount of said second type of radiation (35) passing through said optical layer (22),
- a layer (25) on which said fraction (41) impinges, said layer (25) converting at least part of said fraction (41) to said first type of radiation (39), and
- a substrate (27) substantially transparent to said first type of radiation (39), said measurement system being arranged to derive from said measurement signal at least one of a dose of said amount of second type of radiation (35), an intensity of said second amount (35) of radiation and an amount of contamination of said optical layer (22).

2. Detector arrangement according to claim 1 **characterized in that** said layer (25) comprises a host lattice and at least one ion.

3. Detector arrangement according to claim 2 **characterized in that** said host lattice comprises at least one of calcium sulfide (CaS), zinc sulfide (ZnS) and yttrium aluminum garnet (YAG) and said ion comprises at least one of Ce³⁺, Ag⁺ and Al³⁺.

4. Detector arrangement according any of the preceding claims, **characterized in that** said detector (31) comprises at least one of a CCD camera, a CMOS sensor, and a photodiode array.

5. Detector arrangement according to any of the preceding claims **characterized in that** said optical component (24) comprises a multilayer stack.

6. Detector arrangement according to any of the preceding claims **characterized in that** said multilayer stack comprises at least one layer of silicon (Si) and at least one layer of molybdenum (Mo).

7. Measurement assembly (29) comprising at least a detector arrangement according to any of the preceding claims and an optical component (24) located in the vicinity of said detector (31).

8. Detector arrangement according to any of the claims 1 - 6 or measurement assembly (29) according to claim 7 **characterized in that** said second type of radiation comprises at least one of EUV and IR radiation.

9. Measurement assembly for determining an amount of contamination of an optical layer (22) of an optical component (21), comprising a radiation source (40) arranged to provide, in use, a measurement beam (43) towards said optical component (21), a detector (31) arranged to receive at least a portion (34) of said measurement beam (43) after said measurement beam (43) has passed through said optical component (21) and a measurement system (33) connected to said detector (31) to receive a measurement signal **characterized in that** the measurement system (33) is arranged to determine an amount of contamination of said optical layer (22) from said measurement signal.

10. Measurement assembly according to claim 9 **characterized in that** said radiation source is arranged to provide said measurement beam with at least one of a wavelength in the infra red (IR) part and in the ultra violet (UV) part of the electromagnetic spectrum.

11. A lithographic apparatus comprising.
- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate,
**characterized in that** the lithographic projection apparatus comprises a measurement assembly (29) according to any of the claims 7-10.

12. Method for determining at least one of a dose of radiation (35), an intensity of radiation (35) and an amount of contamination of an optical layer (22) comprising:
- providing a detector arrangement comprising a detector (31) and a measurement system (33), said detector (31) being arranged to provide a measurement signal to said measurement system (33) in response to radiation (39; 41; 34) incident on said detector (31),
**characterized by**
- providing said detector (31) behind an optical component (21; 24) said optical component (21; 24) comprising said optical layer (22) to, when said detector arrangement is in use, receive said radiation (35; 43) a fraction (41; 34) of said radiation (35; 43) passing through said optical layer (22) and
- calibrating said measurement system to derive from said radiation (39; 41; 34) a measurement signal relating to at least one of a dose of said radiation (35), an intensity of said radiation (35) and an amount of contamination of said optical layer (22).

13. A device manufacturing method comprising the steps of:
- providing a substrate;
- providing a projection beam of radiation using an illumination system;
- using patterning means to impart the projection beam with a pattern in its cross-section; and
- projecting the patterned beam of radiation onto a target portion of the substrate,
**characterized by**
using a lithographic apparatus according to claim 8.

14. Detector arrangement comprising a photodiode and a measurement system (33), said photodiode being arranged to provide a measurement signal to said measurement system (33) said photodiode designed to be arranged behind an optical component (21; 24), said optical component (21; 24) comprising an optical layer (22) to, in use, receive an amount of radiation **characterized in that** said measurement signal is related to an amount of contamination on said optical layer (22).
